# EUROPÄISCHE PATENTSCHRIFT

(11) **EP 0 918 586 B1**
(45) Veröffentlichungstag und Bekanntmachung des Hinweises auf die Patenterteilung: **09.06.2004**
(21) Anmeldenummer: 97934491.8
(22) Anmeldetag: 18.07.1997
(51) Int. Cl.: B23B 27/20

(54) **WERKZEUG INSBESONDERE FÜR DIE SPANENDE MATERIALBEARBEITUNG**
TOOL, ESPECIALLY FOR MACHINING
OUTIL SERVANT NOTAMMENT A L'USINAGE

(30) Priorität: 23.07.1996 DE 19629456
(43) Veröffentlichungstag der Anmeldung: 02.06.1999
(73) Patentinhaber: Fraunhofer-Gesellschaft zur Förderung der angewandten Forschung e.V., 80686 München (DE)
(72) Erfinder: FRYDA, Matthias, D-38110 Braunschweig (DE); MATTHEE, Thorsten, D-38527 Meine (DE); SCHÄFER, Lothar, D-38527 Meine (DE); STOLLEY, Tobias, D-38106 Braunschweig (DE)
(74) Vertreter: Einsel, Martin, Dipl.-Phys.
(86) Internationale Anmeldenummer: PCT/EP1997/003865
(87) Internationale Veröffentlichungsnummer: WO 1998/003292

(56) Entgegenhaltungen:
- EP-A- 0 670 192
- PATENT ABSTRACTS OF JAPAN vol. 95, no. 10, 30.November 1995 & JP 07 172987 A (SASAKI), 11.Juli 1995,
- PATENT ABSTRACTS OF JAPAN vol. 18, no. 385 (C-1227), 20.Juli 1994 & JP 06 107494 A (CHIKUNO TAKASHI), 19.April 1994,

## Beschreibung

Die Erfindung betrifft ein Werkzeug, insbesondere für die spanende Materialbearbeitung, mit einer Beschichtung aus einer haftfesten, polykristallinen Diamantschicht sowie außerdem ein Verfahren zur Herstellung eines solchen Werkzeugs.

An Werkzeugen, insbesondere für die spanende Materialbearbeitung, besteht zunehmender Bedarf. Zugleich werden ständig höhere Anforderungen und Ansprüche an diese Werkzeuge gestellt. Sie sollen möglichst haltbar sein, also eine erhöhte Standzeit aufweisen, außerdem sollen die Schneidkanten scharf und wenig verrundet sein.

Derartige Werkzeuge, üblicherweise Hartmetallwerkzeuge, weisen unter anderem Beschichtungen aus TiN- oder Al₂ O₃ auf, insbesondere aber auch Beschichtungen mit einer Diamantschicht. Die Härte und Eignung von Diamant gerade für spanende Materialbearbeitung ist bekannt und bewährt. Eine Diamantschicht muß auf dem Werkzeug haften, sie ist üblicherweise polykristallin. Zur Herstellung sind verschiedene Standardverfahren bekannt, beispielsweise hot filament chemical vapor deposition (HF-CVD) oder Mikro wave chemical vapor deposition (MW-CVD) oder Plasma Jet. Alle Verfahren verwenden eine aktivierte Gasphase. Das Substrat hat während des Beschichtens in der Regel eine Temperatur von 700 °C bis 950 °C. Die verschiedenen Verfahren haben unterschiedliche Nachteile, zusammengestellt etwa bei Lux, Haubner und Renat, "Diamond for toolings and abräsives", in: Diamond and Related Materials 1 (1992), 1035-1047.

Die Schichtdicke der Diamantschicht ist typischerweise größer als 20 µm, was im Verhältnis zu anderen Beschichtungsmaterialien eine relativ große Schichtdicke ist. Nachteilig dabei ist, daß diese große Schichtdicke allein schon aus geometrischen Gründen zu erheblichen Schneidkantenverrundungen führt, was wie oben bereits diskutiert an sich unerwünscht ist.

Aus der EP 0 670 192 A1 ist ein Werkzeug bekannt, bei dem ein Basiswerkzeugteil versehen wird mit einer nachträglich angelöteten Schneidspitze aus einem gesondert hergestellten CVD-Diamantfilm. Dies ist ein mit zusätzlichen Schnitten behaftetes und auch die Eigenschaften des Werkzeugs begrenzendes Herstellungsverfahren, da nur bestimmte flache eine einseitige Schneidkante aufweisende Werkzeuge so hergestellt werden können.

Aus der DE-33 90 522 C2 ist ein spanendes Werkzeug bekannt, bei dem ,eine Beschichtung mit einer Verbindung eines Metalls mit beispielsweise Kohlenstoff vorgesehen ist. Die Beschichtung dient dazu, den chemischen Verschleiß der Werkzeugoberfläche zu reduzieren. Hierzu wird das Werkzeug mit im Vakuum verdampfendem und ionisiertem Metall beschichtet und eine schwach ausgeprägte Textur der entstehenden Kristalle zur Minimierung der freien Energie aufgebaut.

Aufgabe der Erfindung ist es, Werkzeuge mit verbesserten Eigenschaften vorzuschlagen. Außerdem soll ein Verfahren zur Herstellung derartiger Werkzeuge angegeben werden.

Diese Aufgabe wird durch ein Werkzeug gemäß dem Anspruch 1 und ein Verfahren gemäß dem Anspruch 5 gelöst.

Mit einem derartigem Werkzeug wird a) eine deutliche Erhöhung der Standzeit erzielt und b) werden Parameterbereiche der Bearbeitung ermöglicht, die ansonsten nicht zugänglich sind. Der verringerte Verschleiß ermöglicht den Einsatz geringerer Schichtdicken, dadurch erfolgt schon rein geometrisch zugleich eine Verringerung der Schneidkantenverrundung.

Der physikalische Grund hierfür liegt darin, daß es bei dem Texturierten Wachstum während des Beschichtungsvorganges zu einer Ausrichtung der Diamantkristallite kommt. Diese Ausrichtung führt dazu, daß die Kristallflächen insbesondere bei einer (100)-Textur überall parallel zur Substratoberfläche ausgerichtet sind.

Besonders an den Schneidkanten ist dieses interessant. Diese Kristallorientierung dient dazu, die bei der Bearbeitung auftretenden Kräfte auf einzelne Diamantkristalle der polykristallinen Diamantschicht möglichst gering zu halten.

Natürlich ist es bevorzugt, wenn diese Ausrichtung nicht nur an den Schneidkanten, sondern generell auf der gesamten Substratoberfläche so erfolgt. Dies gift insbesondere für andere beanspruchte Bereiche, etwa dort, wo die Spanableitung erfolgt.

Die Textur der Diamantschicht führt zu einer "Panzerung" der Schneidkante. Zum einen verringert dies diejenigen Kräfte, die auf das "Interface" wirken, also auf die Verbindungsfläche von Diamant zu Grundkörper (Substrat) oder auch zwischen Diamant-Zwischenschicht und Grundkörper. Durch die Textur tritt hauptsächlich Druckbelastung ein und es gibt kaum Angriffspunkte für Scherungen. Die Belastung erfolgt in erster Linie nur noch in der Normalen. Andererseits wird der Verschleiß oder Abtrag der Diamantschicht als Folge einer Bearbeitung, also Benutzung des Werkzeuges, deutlich herabgesetzt, da auch hierfür kaum noch exponierte Angriffspunkte vorhanden sind.

Bevorzugt ist es konsequent auch insbesondere, wenn die Diamantschicht auch über die Schneidkanten glatt ist.

Mit dem erfindungsgemäßen Werkzeug ist auch eine sogenannte trockene Zerspanung möglich, also eine Mindermengen- bzw. Minimalmengenschmierung bzw. kühlmittelfreie Zerspanung. Diese "trockene" Zerspanung ist auf Grund ihrer größeren Umweltverträglichkeit durch weniger Abwässer zukunftsträchtig, stellt aber hohe Anforderungen an die eingesetzten Werkzeuge. Die erfindungsgemäßen Werkzeuge können diesen Anforderungen genügen.

Möglich ist auch eine Bearbeitung von abrasiven Legierungen und faser- bzw. partikelverstärkten Materialien.

Texturierte Diamantschichten wurden bisher nicht in Betracht gezogen, da Schutzschichten nach allgemeiner Auffassung stets unter Druckspannungen aufwachsen sollten, um tragende Effekte zu erzielen. Mit insbesondere (100) texturierten Diamantschichten lassen sich jedoch nur äußerst schwer Druckspannungen realisieren, so daß diese für Fachleute nicht bis in den Bereich der Überlegungen gedrungen sind.

Überraschenderweise zeigte sich jedoch, daß bei der erfindungsgemäß bevorzugten Verfahrensweise, nämlich die polykristalline Diamantschicht unter Zugspannungen aufwachsen zu lassen, es durchaus zu stabilen, tragfähigen und eben besonders standfesten und wenig Schneidkantenverrundungen hervorrufenden Diamantschichten kommen kann.

Besonders bevorzugt ist die Verwendung des hot filament chemical vapor deposition (HF-CVD)- Verfahrens, wie es beispielsweise von Bachmann und van Enckevort, "Diamond deposition technologies", in: Diamond and Related Materials 1 (1992) 1021 - 1034 diskutiert und beschrieben wird.

Bei dem Verfahren ist es besonders bevorzugt, wenn die Aktivierung der Gasphase möglichst intensiv ist, was durch eine verhältnismäßig hohe Filamenttemperatur von mehr als 2400 °C, insbesondere vorzugsweise sogar von 2450 °C bis 2550 °C erzielbar ist, also durch Temperaturen, die um gut 500 °C über den herkömmlichen der Gasphase bei solchen Beschichtungen liegen und auch die Obergrenze der bisher beim HF-CVD eingesetzten übersteigen.

Gleichwohl ist es besonders bevorzugt, wenn trotz dieser sehr hohen Temperaturen der Gasphase die Substrattemperatur in einem für HF-CVD ungewöhnlich niedrigen Bereich zwischen 700 °C und 900 °C liegt. Es entsteht also eine sehr große und für diese Verfahren an sich untypisch hohe Differenz zwischen Filamenttemperatur und Substrattemperatur.

Diese niedrige Substrattemperatur kann beispielsweise durch aktive Kühlung, die Anpassung des Filament-Substrat-Abstandes und die Reduzierung der Strahlungswärme durch Anpassung der Filamentdurchmesser im richtigen Temperaturintervall gehalten werden.

Im folgenden wird anhand der Zeichnung ein erfindungsgemäßes Werkzeug im Vergleich zum Stand der Technik schematisch erörtert. Es zeigen:
- Figur 1: ein Werkzeug mit einer Beschichtung nach dem Stand der Technik;
- Figur 2: eine ähnliche Darstellung eines erfindungsgemäßen Werkzeuges.

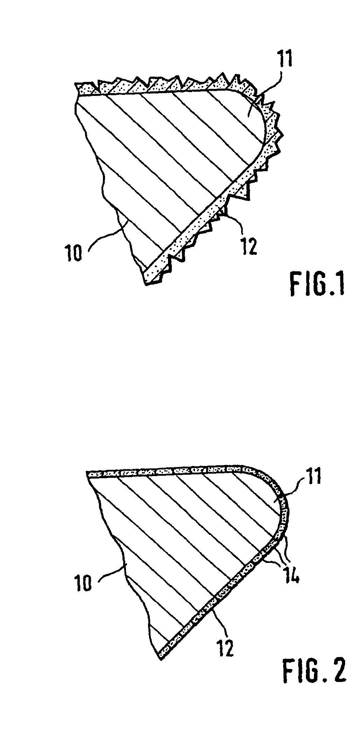

Sowohl Figur 1 als auch Figur 2 zeigen einen Abschnitt aus einem Werkzeug im Bereich einer Schneidkante. Zu erkennen ist dabei das Substrat 10 des eigentlichen Werkzeuges, dessen Hauptmasse sich jeweils links im Bild befindet.

Dieses Substrat 10 wird nun mit einer Diamantschicht 12 versehen. Im Stand der Technik in der Fig. 1 ist diese Diamantschicht statistisch orientiert, so daß sich die einzelnen Diamantkristalle jeweils zufällig anordnen. Diese Diamantschicht 12 ist relativ dick, die Schichtdicke beträgt über 20 µm. Durch die statistische Anordnung stehen relativ viele Zacken und Angriffspunkte nach außen vor, die zu Verschleiß führen und bei Kräfteeinwirkung von außen leicht zu Scherkräften im Interface zwischen der Diamantschicht 12 und dem Substrat 10 führen können. Im Stand der Technik ist ein Hauptaspekt vorzeitigen Verschleißens nicht nur die abrasive Abnutzung der Diamantschicht von außen, sondern ein Abplatzen der Diamantschicht oder von Teilen davon. Dies dürfte an solchen Scherkräften im Interface liegen.

Fig. 2 zeigt über einem praktisch identischen Substrat 10 dagegen eine texturiert aufgewachsene Diamantschicht 12. Zu erkennen ist, daß sich sämtliche einzelnen Diamantkristallite 14 mit ihren Kristallflächen parallel zur Substratoberfläche ausgerichtet haben und zwar auch im Bereich der hier natürlich vergrößert dargestellten Schneidkante 11. Das Werkzeug ist also gleichmäßig mit flachen, oberflächenparallelen Diamantkristalliten 14 bedeckt, was zu einer Art Panzerung führt.

Es stehen praktisch keine Spitzen nach außen vor, die Angriffspunkte bilden könnten. Dies führt - wie bereits Versuche zeigten - zu einer verlängerten Standzeit des gesamten Werkzeugs.

## Patentansprüche

1. Werkzeug, insbesondere für die spanende Materialbearbeitung,
mit einem Substrat (10) mit einer Oberfläche,
mit einer haftfesten, polykristallinen Diamantschicht (12),
wobei die Diamantschicht (12) auf der Oberfläche des Substrates (10) direkt abgeschieden ist,
mit mindestens einer Schneidkante (11),
wobei die Diamantschicht (12) um eine die Schneidkante (11) bildende Krümmung des Substrates (10) herumreicht, und
wobei die Textur relativ zur Oberfläche des Substrates (10) beibehalten wird.

2. Werkzeug nach Anspruch 1,
**dadurch gekennzeichnet,**
**dass** die Diamantschicht (12) auf dem Werkzeug vollständig texturiert ist.

3. Werkzeug nach Anspruch 1 oder 2,
**dadurch gekennzeichnet,**
**dass** die Textur der Diamantschicht (12) eine (100)-Textur ist.

4. Werkzeug nach einem der vorhergehenden Ansprüche
**dadurch gekennzeichnet,**
**dass** die Oberfläche der Diamantschicht (12) auch über die Schneidkanten (11) glatt ist.

5. Verfahren zur Herstellung eines Werkzeugs nach einem der vorstehenden Ansprüche,
**dadurch gekennzeichnet,**
**dass** die Beschichtung des Werkzeuges in einer aktivierten Gasphase vorgenommen wird, wobei die Diamantschichten (12) unter Zugspannungen abgeschieden werden.

6. Verfahren nach Anspruch 5,
**dadurch gekennzeichnet,**
**dass** die aktivierte Gasphase bei einer Filamenttemperatur von mehr als 2400 °C, vorzugsweise zwischen 2450 °C und 2550 °C stattfindet.

7. Verfahren nach Anspruch 5 oder 6,
**dadurch gekennzeichnet,**
**dass** die Substrattemperatur bei der Beschichtung zwischen 700 °C und 900 °C liegt.

8. Verfahren nach einem der Ansprüche 5 bis 7,
**dadurch gekennzeichnet,**
**dass** die Beschichtung mittels hot filament chemical vapor deposition (HF-CVD) vorgenommen wird.

## Claims

1. Tool, in particular for machine-cutting material, comprising a substrate (10) with a surface, comprising an adherent, polycrystalline diamond layer (12), wherein the diamond layer (12) has been vapour-deposited directly on the surface of the substrate (10), comprising at least one cutting edge (11), wherein the diamond layer (12) extends around a curvature of the substrate (10) forming the cutting edge (11), and wherein the texture relative to the surface of the substrate (10) is retained.

2. Tool according to claim 1,
**characterized in**
**that** the diamond layer (12) on the tool is fully textured.

3. Tool according to claim 1 or 2,
**characterized in**
**that** the texture of the diamond layer (12) is a (100) texture.

4. Tool according to one of the preceding claims,
**characterized in**
**that** the surface of the diamond layer (12) is smooth even over the cutting edges (11).

5. Method of manufacturing a tool according to one of the preceding claims,
**characterized in**
**that** the coating of the tool is effected in an activated gas phase, wherein the diamond layers (12) are vapour-deposited under tensile stresses.

6. Method according to claim 5,
**characterized in**
**that** the activated gas phase occurs at a filament temperature of more than 2400 °C, preferably between 2450 °C and 2550 °C.

7. Method according to claim 5 or 6,
**characterized in**
**that** the substrate temperature during coating lies between 700 °C and 900 °C.

8. Method according to one of claims 5 to 7,
**characterized in**
**that** the coating is effected by means of hot filament chemical vapour deposition (HF-CVD).

## Revendications

1. Outil, en particulier pour l'usinage par enlèvement de copeaux, comprenant un support (10) avec une surface munie d'une couche de diamant (12) polycristalline adhérente, la couche de diamant (12) étant déposée directement sur la surface du support (10), avec au moins une arête de coupe (11), la couche de diamant (12) s'étendant autour d'une courbure du support (10), laquelle forme l'arête de coupe (11), et dans lequel la texture par rapport à la surface du support (10) est maintenue.

2. Outil selon la revendication 1, **caractérisé en ce que** la couche de diamant (12) sur l'outil est entièrement texturée.

3. Outil selon la revendication 1 ou 2, **caractérisé en ce que** la texture de la couche de diamant (12) est une texture (100).

4. Outil selon l'une quelconque des revendications précédentes, **caractérisé en ce que** la surface de la couche de diamant (12) est lisse également sur les arêtes de coupe (11).

5. Procédé de fabrication d'un outil selon l'une quelconque des revendications précédentes, **caractérisé en ce que** le processus de revêtement de l'outil est effectué dans une phase gazeuse activée, les couches de diamant (12) étant déposées sous l'effet de contraintes de traction.

6. Procédé selon la revendication 5, **caractérisé en ce que** la phase gazeuse activée est produite avec une température du filament supérieure à 2 400°C, de préférence entre 2 450°C et 2 550°C.

7. Procédé selon la revendication 5 ou 6, **caractérisé en ce que** la température du support pendant le processus de revêtement se situe entre 700°C et 900°C.

8. Procédé selon l'une quelconque des revendications 5 à 7, **caractérisé en ce que** le revêtement est élaboré par un dépôt chimique en phase vapeur à fil chaud (HF-CVD).
